# EUROPEAN PATENT APPLICATION

(11) **EP 2 343 598 A1**
(43) Date of publication of application: **13.07.2011**
(21) Application number: 09814555.0
(22) Date of filing: 14.09.2009
(51) Int. Cl.: G03F 7/32, H01L 21/027, H01L 21/304

(54) **SUBSTRATE PROCESSING LIQUID AND METHOD FOR PROCESSING RESIST SUBSTRATE USING SAME**

(30) Priority: 16.09.2008 JP 2008236575
(71) Applicant: AZ Electronic Materials (Japan) K.K., Tokyo 113-0021 (JP); AZ Electronic Materials USA Corp., Somerville, New Jersey 08876 (US)
(72) Inventor: WANG Xiaowei, Kakegawa-shi Shizuoka 437-1412 (JP); KANG Wenbing, Kakegawa-shi Shizuoka 437-1412 (JP); KATAYAMA Tomohide, Kakegawa-shi Shizuoka 437-1412 (JP); MATSUURA Yuriko, Kakegawa-shi Shizuoka 437-1412 (JP); KOIKE Tohru, Kakegawa-shi Shizuoka 437-1412 (JP)
(74) Representative: Rippel, Hans Christoph
(86) International application number: PCT/JP2009/066035
(87) International publication number: WO 2010/032710

(57) **Abstract**

The present invention provides a resist substrate treating solution and a method employing the solution for treating a resist substrate. This treating solution enables to remove efficiently resist residues remaining on a surface of the resist substrate after development, and further to miniaturize a resist pattern. The solution is used for treating a resist substrate having a developed photoresist pattern, and comprises a solvent incapable of dissolving the photoresist pattern and a polymer soluble in the solvent. The developed resist substrate is brought into contact with the treating solution, and then washed with a rinse solution such as water to remove efficiently resist residues remaining on the resist substrate surface. The solvent and the polymer are preferably water and a water-soluble polymer, respectively.

## Description

### TECHNICAL FIELD

The present invention relates to a resist substrate treating solution with which a developed resist substrate is treated to remove residues or residual films attaching on the substrate surface in a manufacturing process of a semiconductor device or the like. Further, this invention also relates to a method employing the solution for treating a resist substrate.

### BACKGROUD ART

Photolithography has hitherto been used for formation of fine elements or for microfabrication in extensive fields including the manufacture of semiconductor integrated circuits such as LSIs, the preparation of FPD screens and color filters, and the production of circuit boards for thermal heads and the like. In the photolithography, a positive- or negative-working photosensitive resin composition is used for resist pattern formation.

In recent years, according as various devices have been downsized, semiconductor integrated circuits have been required to have more increased integration density and hence resist patterns have been also required to be more miniaturized. However, in accordance with increasing the fineness in fabrication of resist patterns, troubles are liable to increase.

For example, in a process for formation of a resist pattern, there are some cases that resist in the areas to be removed in development treatment partly remains or attaches as residues on the substrate surface, so that it often results in failure to obtain the aimed resist pattern. Further, if the pattern has a narrow groove, the residues may induce bridging over the groove. These troubles occur because the resist composition comprises a component poorly soluble in the developing solution and/or because light for exposure is so interfered by the substrate or the like that the aimed areas of the resist layer are insufficiently exposed to the light. In addition, if the formed resist pattern has a narrow width, the pattern may collapse. Thus, the residues of resist are liable to cause defects and to lower the yield of the products, and hence they are unfavorable.

To cope with the above problems, various techniques for reducing the residues have been studied and developed. For example, resist resins contained in the resist compositions have been improved and it is proposed that components capable of reducing the residues be incorporated in the compositions. Further, as for the development treatment, the developing method has been modified and the developing solution has been improved. Furthermore, it is also proposed to provide an intermediate layer such as an anti-reflection layer so as to improve the layer structure of resist substrate.

In addition to those techniques, it is also studied to treat the substrate with a rinse solution after development. In this method, the surface of the resist is often treated with a rinse solution containing a surfactant and the like, so as to prevent the resist pattern from collapsing and to remove the residues. However, the residues cannot be always completely removed with the rinse solution. This is because the residues remaining on the substrate are often in the form of films having thicknesses of a few nanometers to 10 nanometers, depending on the kind of the resist composition and on other conditions such as the exposure conditions and the development conditions.

### DISCLOSURE OF INVENTION

### PROBLEM TO BE SOLVED BY THE INVENTION

As described above, it has been desired to provide a method for treating a developed resist substrate and a resist substrate treating solution employed therein by which it becomes possible to remove completely the resist residues which conventional techniques have been incapable of removing completely, to remove completely the residual resist films even if they are thick, and thereby to prevent the production yield of devices from deteriorating.

### MEANS FOR SOLVING PROBLEM

The present invention resides in a resist substrate treating solution for treating a resist substrate having a developed photoresist pattern, comprising a solvent which cannot dissolve said photoresist pattern and a polymer soluble in said solvent.

The present invention also resides in a method for treating a resist substrate, wherein a developed resist substrate is treated with a resist substrate treating solution comprising a solvent which cannot dissolve a photoresist pattern on a surface of said resist substrate and a polymer soluble in said solvent, and then the resist substrate is washed.

The present invention further resides in a method for removing resist residues, wherein a developed resist substrate is brought into contact with a resist substrate treating solution comprising a solvent which cannot dissolve a photoresist pattern on a surface of said resist substrate and a polymer soluble in said solvent, and then the resist substrate is subjected to rinse treatment, so as to remove resist residues remaining on the resist substrate surface.

The present invention furthermore resides in a method for controlling dimension of a resist pattern, wherein a developed resist substrate is brought into contact with a resist substrate treating solution comprising a solvent which cannot dissolve a photoresist pattern on a surface of said resist substrate and a polymer soluble in said solvent, and then the resist substrate is subjected to rinse treatment, so that the surface of the resist pattern is removed to control the dimension of the resist pattern.

### EFFECT OF THE INVENTION

The present invention enables to remove completely the resist residues or residual resist films attaching on a surface of the developed resist substrate, and thereby to form a clean resist pattern. Consequently, the present invention can prevent the production yield of devices from deteriorating.

The resist substrate treating solution according to the present invention forms a composite film cooperatively with the resist residues and the resist pattern on the substrate surface. The composite film is then removed in a washing procedure performed subsequently. As a result, the outer surface of the resist pattern is layerwise washed away together with the resist residues, so that the width of the resist pattern can be miniaturized. This means that the width of the resist pattern can be also controlled with the resist substrate treating solution of the present invention.

### BEST MODE FOR CARRYING OUT THE INVENTION

The method of the present invention for treating a resist substrate is described below in detail.
In the method for treating a resist substrate according to the present invention, a developed resist pattern is treated with a resist substrate treating solution. There is no particular restriction on how a resist pattern is developed to obtain the pattern to be treated, and hence any process can be adopted. Accordingly, the lithographic process for preparing the pattern to be treated can be performed in any known manner of forming a resist pattern from a conventional positive- or negative-working photosensitive resin composition. Below described is a typical process for forming the pattern to be treated with the treating solution of the present invention.

First, a photosensitive resin composition is applied on a surface, which can be pretreated, if necessary, of a substrate, such as a silicon substrate or a glass substrate, according to conventional coating method such as spin-coating method, to form a photosensitive resin composition layer.

Any known photosensitive resin composition can be used in pattern formation for the present invention. Representative examples of the compositions usable in the pattern formation include: a composition comprising a quinonediazide type photosensitive substance and an alkali-soluble resin, a chemically amplified photosensitive resin composition (which are positive-working compositions); a composition comprising a photosensitive functional group-containing polymer such as polyvinyl cinnamate, a composition comprising an azide compound such as an aromatic azide compound or a bisazide compound with a cyclized rubber, a composition comprising a diazo resin, and a photo-polymerizable composition comprising an addition-polymerizable unsaturated compound (which are negative-working compositions).

Examples of the quinonediazide type photosensitive substance used in the positive-working composition comprising a quinonediazide type photosensitive substance and an alkali-soluble resin include: 1,2-benzoquinonediazide-4-sufonic acid, 1,2-naphthoquinonediazide-4-sufonic acid, 1,2-naphthoquinonediazide-5-sufonic acid, and sulfonic esters or amides thereof. Examples of the alkali-soluble resin include: novolak resin, polyvinyl phenol, polyvinyl alcohol, and copolymers of acrylic acid or methacrylic acid. The novolak resin is preferably prepared from one or more phenols such as phenol, o-cresol, m-cresol, p-cresol and xylenol in combination with one or more aldehydes such as formaldehyde and paraformaldehyde.

Either positive- or negative-working chemically amplified photosensitive resin composition can be used in the pattern formation for the present invention. The chemically amplified resist generates an acid when exposed to radiation, and the acid serves as a catalyst to promote chemical reaction by which solubility to a developing solution is changed within the areas irradiated with the radiation to form a pattern. For example, the chemically amplified photosensitive resin composition comprises an acid-generating compound, which generates an acid when exposed to radiation, and an acid-sensitive functional group-containing resin, which decomposes in the presence of acid to form an alkali-soluble group such as phenolic hydroxyl or carboxyl group. The composition may comprise an alkali-soluble resin, a crosslinking agent and an acid-generating compound.

The photosensitive resin composition layer formed on the substrate is prebaked, for example, on a hot plate to remove solvent contained in the composition, to form a photoresist layer. The prebaking temperature depends on the solvent and the photosensitive resin composition, but is normally 20 to 200°C, preferably 50 to 150°C.

If necessary, an anti-reflection layer can be beforehand formed by coating under or above the photosensitive resin composition layer. The anti-reflection layer can improve the section shape and the exposure margin.

The photoresist layer is then subjected to exposure through a mask, if necessary, by means of known exposure apparatus such as a high-pressure mercury lamp (i-line, g-line), a metal halide lamp, an ultra-high pressure mercury lamp, a far UV light source, a KrF excimer laser, an ArF excimer laser, a soft X-ray irradiation system, and an electron beam lithography system.

After the exposure, baking treatment may be carried out, if necessary, and then development such as paddle development is carried out to form a resist pattern. The resist is normally developed with an alkali developing solution. Examples of the alkali developing solution include an aqueous solution of sodium hydroxide or tetramethylammonium hydroxide (TMAH).

After the development, the resist pattern is rinsed (washed) with a rinse solution, preferably, pure water, if necessary. This rinse treatment is performed for the purpose of washing away the developing solution remaining on the resist pattern surface. In the present invention, this treatment is therefore referred to as "after-development rinse treatment" in order that it can be distinguished from the rinse treatment (described later in detail) performed after the resist substrate treating solution of the present invention is applied. The after-development rinse treatment is preferably carried out with pure water so that the resist substrate treating solution applied after the development can be prevented from contamination with the developing solution and also so that the resist substrate can be treated with the least amount of the treating solution.

In the method of the present invention for treating a resist substrate, the developed resist pattern is brought into contact with a particular resist substrate treating solution. Subsequently to the development or to the after-development rinse treatment with pure water, the pattern is generally not dried before brought into contact with the treating solution. However, if necessary, the pattern may be dried after the development or after the after-development rinse treatment and then brought into contact with the treating solution. Even so, the effect of the present invention can be obtained.

The method according to the present invention can be used for treating a resist substrate having any pattern size. However, the method provides remarkable improvement when used for such a fine resist pattern that the surface condition and size thereof must be precisely controlled. Accordingly, the method of the present invention is preferably combined with a lithographic process for forming a fine resist pattern, namely, with a lithographic process including exposure to X-rays, electron beams or light of 250 nm or less emitted from a light source such as a KrF excimer laser or an ArF excimer laser. As for the pattern dimension, the method is preferably combined with a lithographic process for forming a resist pattern in which the line width of space in a line-and-space pattern is 300 nm or less, preferably 200 nm or less, or otherwise in which the hole diameter in a contact hole pattern is 300 nm or less, preferably 200 nm or less.

The thickness of the resist pattern is freely selected according to the use, but is generally 0.05 to 5 µm, preferably 0.1 to 2.5 µm, more preferably 0.2 to 1.5 µm. However, the thickness is not restricted and can be properly controlled according to need.

In the method of the present invention, a developed resist pattern is treated with a resist substrate treating solution comprising a solvent which cannot dissolve the resist pattern formed by development and a polymer soluble in the solvent.

One of the objects that the treating solution of the present invention aims at is to remove unfavorable resist residues without changing the shape of the resist pattern formed by development. It is, therefore, necessary that the solvent, which is a main component of the treating solution, cannot dissolve the developed resist pattern. In other words, when the resist pattern is in contact with the solvent, the solvent must not substantially change the thickness or dimension of the pattern. Normally, the resist pattern and the resist polymer that the pattern is made of have the same solubility. Accordingly, the solubility of the resist pattern can be estimated by use of that of the resist polymer. In the present invention, the solvent is regarded as incapable of dissolving the resist pattern if the resist polymer has a solubility of 1 wt% or less in the solvent at room temperature.

There is no particular restriction on the solvent as long as it satisfies the above conditions, and hence any solvent can be adopted. Although depending on the kind of the photoresist pattern, the solvent is generally selected from the group consisting of water, alcohols, ethers, alkanes, cycloalkanes, and mixtures thereof. Examples of the alcohols include methyl alcohol, ethyl alcohol, isopropyl alcohol, butyl alcohol, and octyl alcohol. Further, mixtures of water and alcohols, such as mixtures of methyl alcohol-water and isopropyl alcohol-water, can be used. If the polymer described later is hardly soluble in water, the solvent can be selected from the group consisting of ethers, alkanes, cycloalkanes, higher alcohols insoluble in water, and mixtures thereof. Examples of the solvent in that case include dibutyl ether, dipropyl ether, dihexyl ether, straight-chain or branched-chain alcohols containing 8 or more carbon atoms, heptane, octane, and tetralin. Commercially available petroleum mixing solvents such as Pegazol ([trademark], manufactured by Exxon Mobil Corporation) are also usable. Among the above, water is preferred in consideration of affinity with the developing solution and the rinse solution.

The resist substrate treating solution according to the present invention comprises a polymer. The polymer must be homogeneously soluble in the above-described solvent in order that the resist pattern can evenly coated with the solution and that insoluble residues can be prevented from attaching onto the substrate surface when the resist substrate treating solution is applied thereon to treat the substrate.

The polymer is preferably a water-soluble polymer. Water-soluble polymers are generally soluble in the solvents, such as water, which cannot dissolve the resist pattern. On the other hand, however, water-soluble polymers have high affinity with the resist pattern itself since they comprise hydrophilic groups. Accordingly, they can efficiently remove the resist residues. The polymer is, for example, a copolymer comprising a repeating unit derived from a monomer selected from the group consisting of acrylic acid, methacrylic acid, maleic acid, itaconic acid, vinyl ether, vinyl alcohol, vinyl pyrrolidone, and derivatives thereof. The polymer of any molecular weight can be used according to need, and there is no particular restriction on the weight average molecular weight. However, the weight average molecular weight is generally 500 to 200000, preferably 1000 to 100000. The polymer is preferably capable of forming a film.

The polymer usable in the present invention is not restricted by the above. Two or more polymers can be used in combination. In the case where two or more polymers are used in combination, it is necessary that the polymers as a whole be soluble in the solvent incapable of dissolving the resist pattern.

There is no particular restriction on the concentration of the polymer in the resist substrate treating solution of the present invention, and the concentration is preferably controlled according to the aim and the way of using. It is generally 0.01 to 20 %, preferably 0.1 to 10 %, more preferably 0.1 to 7 % based on the total weight of the resist substrate treating solution. The solution containing the polymer in a high concentration can form a thick coating layer, and hence generally has an advantage in covering the whole surface of the developed resist substrate even if the surface is very rough. On the other hand, however, the solution containing the polymer in a low concentration has a tendency to form a coating layer excellent in evenness.

The resist substrate treating solution according to the present invention indispensably comprises the solvent and the polymer described above, and may further contain other components such as a surfactant for improving the coatability. Various surfactants are known and any of them can be selected according to need. For example, an ionic or nonionic surfactant can be used. Examples of the surfactant include alkyl sulfonic acids, alkyl carboxylic acids, fluorine-containing derivatives thereof, esters or ammonium salts thereof, and surfactants comprising ethylene oxide or propylene oxide in their structures.

The resist substrate treating solution of the present invention may contain an acid, which may be the surfactant described above or another optional component. This acid is optionally incorporated for improving coatability, and hence does not directly contribute to reducing the thickness of the resist pattern.

The resist substrate treating solution of the present invention comprises a solvent which cannot dissolve the resist pattern, but may further comprise a dissolubility-control agent which can dissolve the resist pattern as long as the agent does not impair the effect of the present invention. As described above, the dissolubility-control agent can dissolve the resist pattern. This means that the resist pattern is more soluble in the dissolubility-control agent than in the above-described solvent incapable of dissolving the resist pattern. The dissolubility-control agent in a proper amount can improve efficiency in removing the resist residues.

There is no particular restriction on the dissolubility-control agent provided that it can dissolve the resist pattern and that it can be homogeneously mixed in the resist substrate treating solution. Examples of the dissolubility-control agent include propylene glycol monomethyl ether (hereinafter, referred to as PGME), propylene glycol monomethyl ether acetate (PGMEA), tetraethylene glycol dimethyl ether (hereinafter, referred to as TGDE), 2-(2-ethoxyethoxy)ethanol (hereinafter, referred to as EEE) and tetraethylene glycol (hereinafter, referred to as TEG).

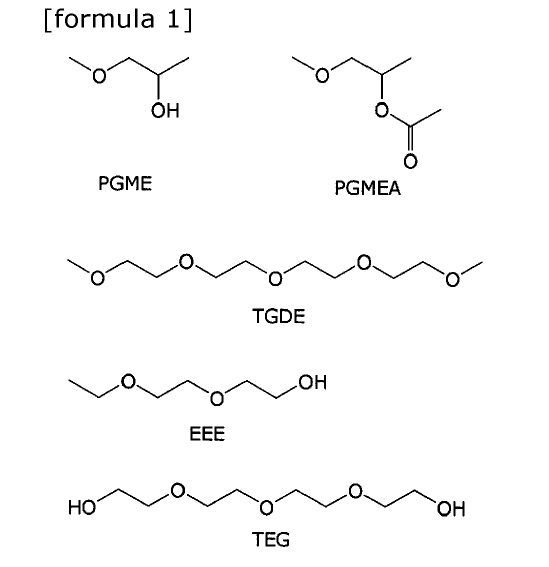

The dissolubility-control agent is not restricted to a liquid at room temperature, and may be so liquefied when heated to a particular temperature that it can dissolve the resist pattern.

If the content of the agent is too high, there is a fear that the structure of the developed resist pattern may be seriously destroyed. However, a proper amount of the dissolubility-control agent can improve efficiency in removing the resist residues. The content of the dissolubility-control agent is preferably 0.1 to 10 wt% based on the total weight of the resist substrate treating solution. Based on the weight of the polymer contained in the resist substrate treating solution, the content of the agent is preferably 0.1 to 30 wt%, more preferably 1 to 15 wt%.

In the method of the present invention, a developed resist substrate is brought into contact with the resist substrate treating solution described above, and then the substrate is subjected to rinse treatment. For bringing the substrate into contact with the resist substrate treating solution, the substrate may be immersed in the solution or coated with the solution by dipping or paddle-coating, for example. How long the substrate is kept in contact with the solution, namely, the treating time, is not particularly restricted. However, in order to obtain fully the effect on removing the resist residues from the substrate, the treating time is preferably 1 second or more, further preferably 10 seconds or more. The upper limit of the treating time is not particularly restricted, but is preferably 300 seconds or less in view of production efficiency.

There is also no particular restriction on the temperature of the resist substrate treating solution, but it is normally 5 to 50°C, preferably 20 to 30°C in view of efficiency in removing the residues on the substrate.

In the method according to the present invention, the resist substrate is subjected to washing treatment, namely, rinse treatment, after brought into contact with the above resist substrate treating solution. The rinse treatment is performed for the purposes of washing away the resist substrate treating solution and, at the same time, of removing the resist residues or residual films whose solubility is changed by the resist substrate treating solution. In the rinse treatment, the resist residues or residual films remaining after development are removed and thereby the aimed resist pattern is formed. Therefore, the rinse treatment after applying the resist substrate treating solution is indispensable to the method of the present invention. The rinse treatment is preferably carried out with a rinse solution capable of dissolving the polymer contained in the resist substrate treating solution so that the polymer may not remain on the resist substrate. In other words, the polymer contained in the resist substrate treating solution is preferably highly soluble in the rinse solution. If the resist substrate treating solution comprises two or more polymers, the polymers as a whole are preferably highly soluble in the rinse solution and each of the polymers preferably has high solubility in the rinse solution.

The rinse solution used in the rinse treatment is normally pure water. Particularly in the case where the polymer is water-soluble, pure water is preferred because the polymer can be effectively washed away and further because it is advantageous from the viewpoints of safety and cost. However, other rinse solutions can be adopted according to the components of the resist substrate treating solution. For example, the rinse solution may be an aqueous solution obtained by adding a surfactant to pure water, or the solvent contained in the resist substrate treating solution is also usable as the rinse solution. Further, for effectively removing the resist residues, aqueous solutions containing alkaline compounds such as teteramethyl ammonium hydroxide (hereinafter, referred to as TMAH) and sodium hydroxide can be used. As the alkaline compound-containing aqueous solutions, developing solutions for the resist can be used directly or after the concentrations thereof are changed.

The rinse treatment can be performed in any manner. For example, the resist substrate may be immersed in the rinse solution, or otherwise the rinse solution may be dropped, sprayed or jetted onto the substrate while the substrate is kept spinning.

When the resist substrate is treated with the resist substrate treating solution of the present invention, it is presumed that the resist residues remaining after development are removed by the following mechanism.

Generally after a resist substrate is developed, a part of the resist that ought to have been removed is liable to remain or attach on the substrate surface as residues. For example, when photoresist after imagewise exposed is developed, the resist in the areas exposed to light if it is negative-working or otherwise in the areas not exposed to light if it is positive-working is expected to be removed by development, and accordingly the substrate surface in those areas should be bared. Actually, however, the residues or residual films of the resist often remain or attach on the substrate surface in the areas where the substrate surface ought to be bared. If the resist substrate treating solution of the invention is applied on such surface of the developed resist substrate, the solubility of the resist surface is so changed by the solution that the resist surface becomes more soluble. That is because the polymer contained in the solution has enough compatibility with the photoresist. On the other hand, however, since the solvent contained in the solution cannot dissolve the photoresist, the shape of the resist pattern is not destroyed. As a result, since the residues or residual films of the resist have relatively thin thicknesses as compared with the resist pattern, they are made soluble enough to be removed in the rinse treatment preformed thereafter.

When the resist residues are thus removed, the resist substrate treating solution works not only on the resist residues but also on the outer surface of the resist pattern. This means that the resist substrate treating solution also affects the solubility of the outer surface of the resist pattern enough to be removed in the rinse treatment preformed thereafter. As a result, the outer surface, namely, the top and side surface of the resist pattern is removed to narrow the pattern width. If the pattern has a contact hole, the inner surface of the hole is layerwise removed to enlarge the hole diameter. Accordingly, the dimension of the resist pattern can be controlled by treating the developed resist pattern with the resist substrate treating solution of the present invention.

The method of the present invention for treating a resist substrate can be combined with baking, so as to promote removing the resist residues or to control how much the pattern dimension is changed. For example, the resist substrate can be subjected to baking before the contact with the resist substrate treating solution or otherwise before the rinse treatment after the contact with the resist substrate treating solution. The baking treatment changes properties of the resist pattern and/or interaction between the resist pattern and the resist substrate treating solution, and thereby makes it possible to promote removing the residues or to control the degree of the pattern dimension change.

After the resist residues are removed or the dimension is controlled by the method of the present invention, the resist pattern is then fabricated according to the use. The method of the present invention does not particularly restrict the fabrication, and hence the resist pattern can be fabricated in a conventional manner.

The pattern formed by the method of the present invention can be employed for manufacture of semiconductor devices, flat panel displays (FPDs) such as liquid crystal displays element, charge-coupled devices (CCDs), color filters, magnetic heads and the like, in the same manner as a pattern formed by the conventional method is employed for.

The present invention is further explained by use of the following Examples, but they by no means restrict embodiments of the present invention.

### Examples 1 to 4

First, a silicon substrate was coated with a bottom anti-reflection layer-forming composition of KrF exposure type (KrF-17B [trademark], manufactured by AZ Electronic Materials (Japan) K.K.), to form an anti-reflection layer of 80 nm thickness. After that, a KrF resist composition (DX5250P [trademark], manufactured by AZ Electronic Materials (Japan) K.K.) was applied thereon to form a layer of 440 nm thickness, and then subjected to baking at 90°C for 60 seconds to obtain a substrate having a resist layer.

Subsequently, resist substrate treating solutions listed in Table 1 were prepared. Each solution was prepared by dissolving a polymer and other components in ultra pure water and then by filtrating the obtained solution though a UPE filter (pore size: 0.05 µm) (manufactured by Nihon Entegris K.K.). The polymer was powdery polyvinyl pyrrolidone (hereinafter, referred to as PVP) (weight average molecular weight: 3000) or polymaleic acid (weight average molecular weight: 5000). Further, as optional additives, a straight-chain alkyl sulfonic acid containing approx. 12 carbon atoms (surfactant) and TGDE (dissolubility-control agent) were used.

The above-prepared resist substrate was coated with each resist substrate treating solution listed in Table 1, and then subjected to baking at 120°C for 60 seconds, and finally rinsed with pure water to remove the resist substrate treating solution remaining on the substrate surface. The thickness of the resist layer was measured before and after the treatment with the resist substrate treating solution, and the change of the thickness was calculated. The results were as set forth in Table 1. From the results, it was found that the outer surface of the resist pattern could be so removed as to control the width and thickness of the pattern by treating the resist substrate with the resist substrate treating solution.

[Table 1]

**Table 1**

| | Polymer | | Agent (TGDE) | Straight-chain alkyl sulfonic acid | Reduction in thickness |
|---|---|---|---|---|---|
| | Substance | Content* | Content* | Content* | |
| Ex.1 | PVP | 6 wt% | - | - | 0.3 nm |
| Ex.2 | PVP | 6 wt% | - | 0.06 wt% | 0.6 nm |
| Ex.3 | polymaleic acid | 3 wt% | - | - | 9.7 nm |
| Ex.4 | polymaleic acid | 3 wt% | 1 wt% | - | 10.7 nm |

| | | | | | |
|---|---|---|---|---|---|
| Remark*: The contents are based on the total weigh of the treating solution. | | | | | |

### Examples 3A to 3D

A silicon substrate was coated with a bottom anti-reflection layer-forming composition of KrF exposure type (KrF-17B [trademark], manufactured by AZ Electronic Materials (Japan) K.K.), to form an anti-reflection layer of 80 nm thickness. After that, a KrF resist composition (DX5250P [trademark], manufactured by AZ Electronic Materials (Japan) K.K.) was applied thereon to form a layer of 440 nm thickness, and then subjected to baking at 90°C for 60 seconds to obtain a substrate having a resist layer. The obtained substrate was subjected to exposure by means of a KrF exposure apparatus (FPA-EX5 [trademark], manufactured by Canon Inc.), and was thereafter developed to produce a developed resist substrate having a contact hole pattern of 200 nm with a pitch of 1:1.

The developed resist substrate produced thus was coated with a resist substrate treating solution prepared in the same manner as in Example 3, and then rinsed with water. The hole dimension was measured before and after the treatment with the resist substrate treating solution, and the change of the hole dimension was calculated. Independently, the same procedure was repeated except that each baking treatment listed in Table 2 was carried out before the rinse treatment with water, to measure the change of the hole dimension. The results were as set forth in Table 2. Here the change of the hole dimension is identical with the change of the hole diameter, and hence it means that the inner wall of the hole was layerwise removed in the thickness corresponding to half of the change shown in Table 2. From the results, it was verified that how much the resist layer was removed could be controlled by the baking conditions and accordingly that the hole dimension could be controlled by them.
[Table 2]

**Table 2**

| | Conditions of baking treatment | Change of the hole dimension (nm) |
|---|---|---|
| Example 3A | not baked | 1.0 |
| Example 3B | 40°C/60 seconds | 6.0 |
| Example 3C | 80°C/60 seconds | 8.8 |
| Example 3D | 120°C/60 seconds | 10.2 |

### Examples 5 to 10 and Comparative Example 1

First, resist substrate treating solutions listed in Table 3 were prepared. Each solution was prepared by dissolving a polymer and other components in ultra pure water and then by filtrating the obtained solution though a UPE filter (pore size: 0.05 µm) (manufactured by Nihon Entegris K.K.). The polymer was polyvinyl pyrrolidone (weight average molecular weight: 3000), polyacrylic acid (weight average molecular weight: 50000) or polymaleic acid (weight average molecular weight: 5000). Further, a straight-chain alkyl sulfonic acid containing approx. 12 carbon atoms (surfactant) and TGDE (dissolubility-control agent) were used as optional additives.

Subsequently, in order to evaluate reductions in thickness and in dimension, a developed resist substrate was prepared in the following manner. A silicon substrate was coated with a bottom anti-reflection layer-forming composition of KrF exposure type (KrF-17B [trademark], manufactured by AZ Electronic Materials (Japan) K.K.), to form an anti-reflection layer of 80 nm thickness. After that, a KrF resist composition (DX5240P [trademark], manufactured by AZ Electronic Materials (Japan) K.K.) was applied thereon to form a layer of 200 nm thickness, and then subjected to baking at 120°C for 90 seconds to obtain a substrate having a resist layer. The obtained substrate was subjected to exposure by means of a KrF exposure apparatus (FPA-EX5 [trademark], manufactured by Canon Inc.), and was thereafter developed to produce a developed resist substrate having a line pattern of 250 nm with a pitch of 1:1. Thus, a developed resist substrate for evaluating reductions in thickness and in dimension was prepared.

On the developed resist substrate prepared thus, each resist substrate treating solution listed in Table 3 was spin-coated at 1000 rpm. Immediately then or after subjected to baking at 110°C for 70 seconds, the substrate was rinsed with 2.38% TMAH aqueous solution. The thickness and line dimension of the resist pattern in unexposed areas were measured before and after the treatment with the resist substrate treating solution, and the changes thereof were calculated. The results were as set forth in Table 4.

Thereafter, in order to evaluate residual resist films, another developed resist substrate was prepared in the following manner. On a silicon substrate having a silicon dioxide layer of 300 nm thickness, hexamethyldisilazane was vapor-deposited at 120°C for 35 seconds. The substrate was then coated with a KrF resist composition (DX7260P [trademark], manufactured by AZ Electronic Materials (Japan) K.K.) to form a layer of 200 nm thickness, and subsequently subjected to baking at 120°C for 90 seconds. After that, a top anti-reflection layer-forming composition (AQUATER VIII-A45 [trademark], manufactured by AZ Electronic Materials (Japan) K.K.) was applied thereon to form a layer of 45 nm thickness, and then subjected to baking at 90°C for 60 seconds to prepare a substrate having a resist layer. The obtained substrate was subjected to exposure by means of a KrF exposure apparatus (FPA-EX5 [trademark], manufactured by Canon Inc.), and finally developed to produce a developed resist substrate for evaluating residual resist films. The produced substrate had a line pattern of 250 nm with a pitch of 1:1, and there were residual films in space areas of the pattern.

On the developed resist substrate prepared thus, each resist substrate treating solution listed in Table 3 was spin-coated at 1000 rpm. Immediately then or after subjected to baking at 110°C for 70 seconds, the substrate was rinsed with 2.38% TMAH aqueous solution. The space areas of the resist pattern were observed by cross-sectional SEM before and after the treatment with the resist substrate treating solution, and thereby it was judged by eyes whether or not the treatment was effective in removing the residual films. The results were as set forth in Table 4.

[Table 3]

**Table 3**

| | Polymer | | Agent (TGDE) | Straight-chain alkyl sulfonic acid |
|---|---|---|---|---|
| | Substance | Content* | Content* | Content* |
| Ex.5 | PVP | 6 wt% | - | 1.8 wt% |
| Ex.6 | PVP | 6 wt% | - | 3.6 wt% |
| Ex.7 | PVP | 6 wt% | - | 6 wt% |
| Ex.8 | PVP | 6 wt% | 0.6 wt% | 0.6 wt% |
| Ex.9 | polyacrylic acid | 3 wt% | - | - |
| Ex.10 | polymaleic acid | 3 wt% | - | - |
| Com.1 | The treating soluiton was not used. | | | |

| | | | | |
|---|---|---|---|---|
| Remark*: The contents are based on the total weight of the treating solution. | | | | |

[Table 4]

**Table 4**

| | Reduction in thickness (nm) | | Reduction in dimension (nm) | | Effect on removing the residual films | |
|---|---|---|---|---|---|---|
| | Baked | Non-baked | Baked | Non-baked | Baked | Non-baked |
| Ex.5 | 23.6 | 41 | 24.8 | 42.8 | effective | effective |
| Ex.6 | 24.7 | 58.8 | 26.1 | 78.4 | effective | effective |
| Ex.7 | 33.7 | 104.1 | 14.4 | >100 | effective | effective |
| Ex.8 | 81.7 | 46.5 | >100 | >100 | effective | effective |
| Ex.9 | 22.8 | 32.5 | 9.6 | 28.5 | effective | effective |
| Ex.10 | 60.2 | 168.3 | 75.2 | >100 | effective | effective |
| Corm.1 | 21.9 | 30 | 19 | 33.6 | ineffective | ineffective |

### Example 3E and Comparative Example 2

A silicon substrate was coated with a bottom anti-reflection layer-forming composition of KrF exposure type (KrF-17B [trademark], manufactured by AZ Electronic Materials (Japan) K.K.), to form an anti-reflection layer of 80 nm thickness. After that, a KrF resist composition (DX5250P [trademark], manufactured by AZ Electronic Materials (Japan) K.K.) was applied thereon, and then baked to obtain a substrate having a resist layer. The obtained substrate was subjected to exposure, and thereafter developed to produce a developed resist pattern. The development was performed intentionally with a small amount of a developing solution in a short time, and thereby resist residues were made to remain on the substrate surface.

The developed resist substrate produced thus was coated with a resist substrate treating solution prepared in the same manner as in Example 3, and then rinsed with water (Example 3E). Before and after the treatment with the resist substrate treating solution, the substrate surface was observed with a scanning electron microscope (CDSEM S-9200 Type [trademark], manufactured by HITACHI, Ltd.). As a result, it was verified that the resist residues were removed by the treatment with the resist substrate treating solution of the present invention.

Subsequently, by way of comparison with Example 3E, the resist pattern was treated only with an aqueous surfactant solution and evaluated in the following manner (Comparative Example 2). A silicon substrate was coated with a KrF resist composition (DX5250P [trademark], manufactured by AZ Electronic Materials (Japan) K.K.) and then baked to obtain a substrate having a resist layer. The obtained substrate was subjected to exposure, and then developed to produce a developed resist pattern. The resist substrate produced thus was rinsed with an aqueous surfactant solution (nonionic surfactant: SPC-116A [trademark], manufactured by AZ Electronic Materials (Japan) K.K.), and then washed with water. The thickness of the resist pattern in unexposed areas was measured before and after the treatment, and thereby it was found that the thickness increased by 2 nm. This result indicates that the conventional surfactant treatment cannot miniaturize a resist substrate.

### Examples 11 to 14 and Comparative Example 3

First, a silicon substrate was coated with a bottom anti-reflection layer-forming composition of KrF exposure type (KrF-17B [trademark], manufactured by AZ Electronic Materials (Japan) K.K.), to form an anti-reflection layer of 80 nm thickness. After that, a KrF resist composition (DX7260P [trademark], manufactured by AZ Electronic Materials (Japan) K.K.) was applied thereon to form a layer of 200 nm thickness, and then subjected to baking at 120°C for 90 seconds to obtain a substrate having a resist layer. The obtained substrate was subjected to exposure by means of a KrF exposure apparatus (FPA-EX5 [trademark], manufactured by Canon Inc.), and was thereafter developed to produce a developed resist substrate having a line pattern of 250 nm with a pitch of 1:1.

Subsequently, resist substrate treating solutions listed in Table 5 were prepared. Each solution was prepared by dissolving a polymer and a dissolubility-control agent in ultra pure water and then by filtrating the obtained solution though a UPE filter (pore size: 0.05 µm) (manufactured by Nihon Entegris K.K.). The polymer was powdery polyvinyl pyrrolidone (weight average molecular weight: 3000) or a copolymer in which vinyl alcohol and vinyl acetate were polymerized in a molecular ratio of 87:13 (hereinafter, referred to as PVA copolymer, weight average molecular weight: 28000). As the dissolubility-control agent, TGDE was used.

On the developed resist substrate prepared above, each resist substrate treating solution was spin-coated at 1000 rpm. Immediately then, the substrate was rinsed with 2.38% TMAH aqueous solution. The thickness and line dimension of the resist pattern in unexposed areas were measured before and after the treatment with the resist substrate treating solution, and the changes thereof were calculated. The results were as set forth in Table 5.

[Table 5]

**Table 5**

| | Polymer | | Agent (TGDE) | Straight-chain alkyl sulfonic acid | Reduction in thickness | Reduction in dimension |
|---|---|---|---|---|---|---|
| | Substance | Content* | Content* | Content* | | |
| Ex.11 | PVP | 6 wt% | 0.06 wt% | - | 23.1 nm | 17.4 nm |
| Ex.12 | PVP | 6 wt% | 0.3 wt% | - | 43.0 nm | 31.7 nm |
| Ex.13 | PVP | 6 wt% | 0.6 wt% | - | 74.7 nm | 78.0 nm |
| Ex.14 | PVA copolymer | 6 wt% | 0.6 wt% | - | 79.5 nm | >100 nm |
| Com.3 | The treating soluiton was not used. | | | | 21.8 nm | 16.8 nm |

| | | | | | | |
|---|---|---|---|---|---|---|
| Remark*: The contents are based on the total weigh of the treating solution. | | | | | | |

### Example 15 and Comparative Example 4

A silicon substrate was coated with a bottom anti-reflection layer-forming composition of ArF exposure type (ArF1C5D [trademark], manufactured by AZ Electronic Materials (Japan) K.K.), to form an anti-reflection layer of 37 nm thickness. After that, an ArF resist composition (AX1120P [trademark], manufactured by AZ Electronic Materials (Japan) K.K.) was applied thereon to form a layer of 200 nm thickness, and then subjected to baking at 120°C for 90 seconds to obtain a substrate having a resist layer. The obtained substrate was subjected to exposure by means of an ArF exposure apparatus (NSR-S306C [trademark], manufactured by Nikon Corp.), and was thereafter developed to produce a developed resist substrate having a line pattern of 120 nm with a pitch of 1:1.

On the developed resist substrate produced thus, a resist substrate treating solution prepared in the same manner as in Example 14 was spin-coated at 1000 rpm. The substrate was then rinsed with 2.38% TMAH aqueous solution, and further washed with water (Example 17). As a result, it was found that the line dimension was reduced by 30 nm between before and after the treatment with the resist substrate treating solution.

Independently, by way of comparison, the developed resist substrate produced above was not brought into contact with the resist substrate treating solution, and was directly rinsed with 2.38% TMAH aqueous solution, followed by washing with water (Comparative Example 4). In this case, the line dimension was reduced by 3 nm.

## Claims

1. A resist substrate treating solution for treating a resist substrate having a developed photoresist pattern, comprising a solvent which cannot dissolve said photoresist pattern and a polymer soluble in said solvent.

2. The resist substrate treating solution according to claim 1, wherein said polymer is a water-soluble polymer.

3. The resist substrate treating solution according to claim 2, wherein said water-soluble polymer is a copolymer comprising a repeating unit derived from a monomer selected from the group consisting of acrylic acid, methacrylic acid, vinyl alcohol, vinyl pyrrolidone, and derivatives thereof.

4. The resist substrate treating solution according to any of claims 1 to 3, wherein said solvent is selected from the group consisting of water, alcohols and mixtures thereof.

5. The resist substrate treating solution according to claim 4, wherein said solvent comprises water.

6. The resist substrate treating solution according to any of claims 1 to 5, wherein further comprising a dissolubility-control agent, 0.1 to 10 wt% of the total weight of said treating solution, which can dissolve said photoresist pattern.

7. The resist substrate treating solution according to any of claims 1 to 6, wherein further comprising a surfactant.

8. A method for treating a resist substrate, wherein a developed resist substrate is brought into contact with a resist substrate treating solution comprising a solvent which cannot dissolve a photoresist pattern on a surface of said resist substrate and a polymer soluble in said solvent, and then the resist substrate is subjected to rinse treatment.

9. The method for treating according to claim 8, wherein a developed resist substrate is brought into contact with said resist substrate treating solution, and subsequently subjected to baking, and then subjected to rinse treatment.

10. The method for treating according to claim 8 or 9, wherein said polymer is soluble in a rinse solution used in said rinse treatment.

11. A method for removing resist residues, wherein a developed resist substrate is brought into contact with a resist substrate treating solution comprising a solvent which cannot dissolve a photoresist pattern on a surface of said resist substrate and a polymer soluble in said solvent, and then the resist substrate is subjected to rinse treatment, so as to remove resist residues remaining on the resist substrate surface.

12. A method for controlling dimension of a resist pattern, wherein a developed resist substrate is brought into contact with a resist substrate treating solution comprising a solvent which cannot dissolve a photoresist pattern on a surface of said resist substrate and a polymer soluble in said solvent, and then the resist substrate is subjected to rinse treatment, so that the surface of the resist pattern is removed to control the dimension of the resist pattern.
